(19) Europäisches Patentamt / European Patent Office / Office européen des brevets

(11) **EP 4 019 990 B1**

(12) **EUROPEAN PATENT SPECIFICATION**

(45) Date of publication and mention
of the grant of the patent:
**06.11.2024  Bulletin 2024/45**

(21) Application number: **20383165.6**

(22) Date of filing: **28.12.2020**

(51) International Patent Classification (IPC):
*G01R 27/02* $^{(2006.01)}$       *G01R 31/52* $^{(2020.01)}$
*G01R 27/18* $^{(2006.01)}$       *G01R 19/25* $^{(2006.01)}$
*G01R 31/00* $^{(2006.01)}$

(52) Cooperative Patent Classification (CPC):
**G01R 27/025;** G01R 19/2509; G01R 27/18;
G01R 31/007; G01R 31/52

(54) **SYSTEMS AND METHODS FOR DETERMINING INSULATION RESISTANCE**

SYSTEME UND VERFAHREN ZUR BESTIMMUNG DES ISOLATIONSWIDERSTANDS

SYSTÈMES ET PROCÉDÉS PERMETTANT DE DÉTERMINER LA RÉSISTANCE D'ISOLATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**29.06.2022  Bulletin 2022/26**

(73) Proprietor: **Fico Triad, S.A.**
**08028 Barcelona (ES)**

(72) Inventor: **Abomailek Rubio, Carlos**
**08232 Viladecavalls (Barcelona) (ES)**

(74) Representative: **Bardehle Pagenberg S.L.**
**Avenida Diagonal 598, 3º, 1ª**
**08021 Barcelona (ES)**

(56) References cited:
**EP-A1- 3 675 302**        **EP-B1- 3 675 302**
**US-A- 3 883 724**        **US-A1- 2014 095 093**
**US-A1- 2017 016 951**        **US-A1- 2019 351 771**
**US-A1- 2020 217 899**

**Description**

The present disclosure relates to a system and a method for determining an insulation resistance value in an electrically powered vehicle, in particular between a battery and the chassis of the vehicle.

BACKGROUND

Improving safety and comfort is always a concern in the automotive industry. For electrically powered vehicles, such as electric or hybrid powered vehicles, insulation of the high voltage battery is of significant importance to guarantee safety of the entire vehicle and its occupants. A high voltage battery in the present disclosure may be regarded as a battery with a nominal voltage of 50V or more, and specifically 100V or more.

The battery of a vehicle functions as an energy storage element for powering an electrical motor and thus enabling the vehicle to move. The battery may be part of the floor structure of the vehicle. A battery may include several cells, e.g lithium-ion cells grouped into modules.

The chassis of a vehicle such as a car may generally be considered a vehicle frame providing structural support of the vehicle. The chassis may be mainly made of steel. Specific insulation cabling, materials and coatings may be used to insulate the chassis from the battery. However, battery cable insulation and materials may deteriorate gradually or suddenly. Environmental factors such as humidity influence the insulation resistance as well.

Accordingly, electrically powered vehicles may require systems that check whether the insulation level of the battery is adequate or not before performing specific tasks. Such a task is for instance the start of the electrically powered vehicle, which may be dangerous for the occupants or even the vehicle itself if the battery is poorly insulated.

Therefore, before enabling the start of the vehicle, an electrical resistance between the battery and the chassis may need to be determined. This resistance will be referred to in the present disclosure as insulation resistance.

Depending on the value of the insulation resistance, e.g. if it is higher or lower than a predetermined threshold value, the start of the vehicle may be enabled or disabled.

US 2017/0016951 A1 discloses an insulation resistance measuring device and method for calculating insulation resistance.

Currently, commercial sensors facilitating the determination of the insulation resistance exist. However, on average, sensors of this kind usually require about 2 seconds to obtain a rough measurement and about 20 seconds to obtain a definite value. The 2-second time measurement just provides an indication in the event of very serious isolation fault.

Thus, in order to implement such a system safely, a driver may have to wait a considerable time (a few seconds or more) before a check has been performed on whether the insulation between the battery and the chassis is sufficient for a safe start of the vehicle. This time corresponds with the time needed to obtain the definite insulation resistance value.

The present disclosure provides, methods and systems that aim to avoid or reduce at least some of the aforementioned advantages.

SUMMARY

In an aspect of the present disclosure, a system for measuring an insulation resistance between a battery and a chassis of an electrically powered vehicle is provided in accordance with claim 1. The system comprises a voltage divider being configured to be connected in parallel with the battery and the chassis. The voltage divider comprises a first portion including a switch and a second portion including a first resistor. The first resistor and the switch are connected in series. The system further comprises a switch control unit configured to change a state of the switch; a voltage measurement unit configured to measure the voltage across the first resistor; and a voltage extrapolation unit configured to obtain a stationary value of the voltage at the first resistor by extrapolating two or more voltage values measured by the voltage measurement unit.

According to this aspect, an insulation resistance value may be determined more quickly, particularly because of the use of the voltage extrapolation unit. The voltage extrapolation unit avoids having to wait for a voltage over the resistor to stabilize, thus saving time in determining this voltage.

Therefore, an insulation resistance value may be quickly obtained by the use of a voltage divider comprising a single switch.

In examples of this aspect, the determination of two stationary voltage values across the resistor of measurement in a voltage divider may be used to determine an insulation resistance value.

The stationary voltages are determined by extrapolation.

Herein, an insulation resistance may be understood as an indicator of the electrical resistance between the battery and the chassis. The insulation resistance may include two values, one with respect to the positive terminal of the battery ($R_{ISO,P}$) and another one with respect to the negative terminal of the battery ($R_{ISO,N}$).

Herein, a voltage divider may be understood as an electrical circuit able to turn a large voltage into a smaller one. A voltage divider may for instance include two resistors.

Herein, extrapolating may be understood as predicting a value based on extending a known ensemble of values beyond the range covered by the known values.

Herein, a stationary voltage may refer to a voltage that no longer evolves with time due to the fact that the cause previously making it vary has stopped. For example, if a capacitor is being charged and this is making a voltage to vary, the voltage may become stationary when the capacitor is fully charge and thus no longer causes the voltage to vary. When the voltage is stationary it may be said that the voltage is in a stationary state.

In a further aspect of the present disclosure, a method according to claim 9 for measuring an insulation resistance between a battery and a chassis of an electrically powered vehicle by the system described throughout this disclosure is provided. The method comprises starting the battery; measuring a first plurality of voltages across the first resistor by the voltage measurement unit; determining a first stationary voltage across the first resistor based on an extrapolation of the first plurality of voltages by the voltage extrapolation unit, and interrupting the extrapolation; changing a state of the switch by the switch control unit; measuring a second plurality of voltages across the first resistor by the voltage measurement unit; determining a second stationary voltage across the first resistor based on an extrapolation of the second plurality of voltages by the voltage extrapolation unit and interrupting the extrapolation; and calculating the insulation resistance using the determined first and second stationary voltages across the first resistor.

BRIEF DESCRIPTION OF THE DRAWINGS

The following figures are provided for enabling a good understand of various aspects of the present disclosure, but should not be considered as limiting in any way.

Figure 1 schematically illustrates a voltage divider according to an example connected to a battery and a chassis.

Figure 2 schematically illustrates a system for measuring an insulation resistance according to an example.

Figure 3 schematically represents the effect of changing a state of the switch in the evolution of the voltage across the first resistor when a stationary state in the voltage is reached.

Figure 4 schematically represents the determination of a first stationary voltage across the first resistor by extrapolation and a subsequent change of state of the switch and thus of measured voltage according to an example.

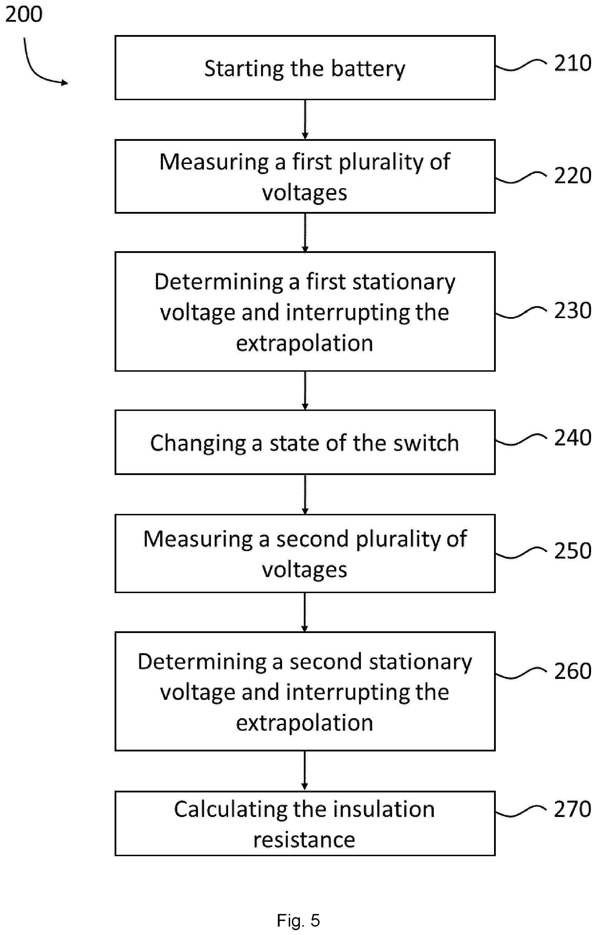

Figure 5 shows a flowchart of a method for measuring an insulation resistance between a battery and a chassis of an electrically powered vehicle.

Figure 6 schematically illustrates the electric circuit of figure 1 in the stationary state when the switch is open according to an example.

Figure 7 schematically illustrates the electric circuit of figure 1 in the stationary state when the switch is closed according to an example.

DETAILED DESCRIPTION OF EXAMPLES

Even though examples are particularly shown for a system and a method for determining an insulation resistance in electrically powered vehicles throughout this disclosure, the same system and method may be used in hybrid vehicles and other electrical machines and/or in other applications as well.

In ideal conditions, an electrical circuit between the chassis , represented by a ground 50, and the battery 10 would be fully resistive. Thus, an insulation resistance 30 may be provided between the terminals of the battery 10 and the chassis 50. In particular, an insulation resistance $R_{ISO,P}$ may be provided between the positive (+) terminal of the battery 10 and the chassis 50, and an insulation resistance $R_{ISO,N}$ may be provided between the negative (-) terminal of the battery 10 and the chassis 50. In this situation, a voltage measured between the battery and the chassis would be substantially constant.

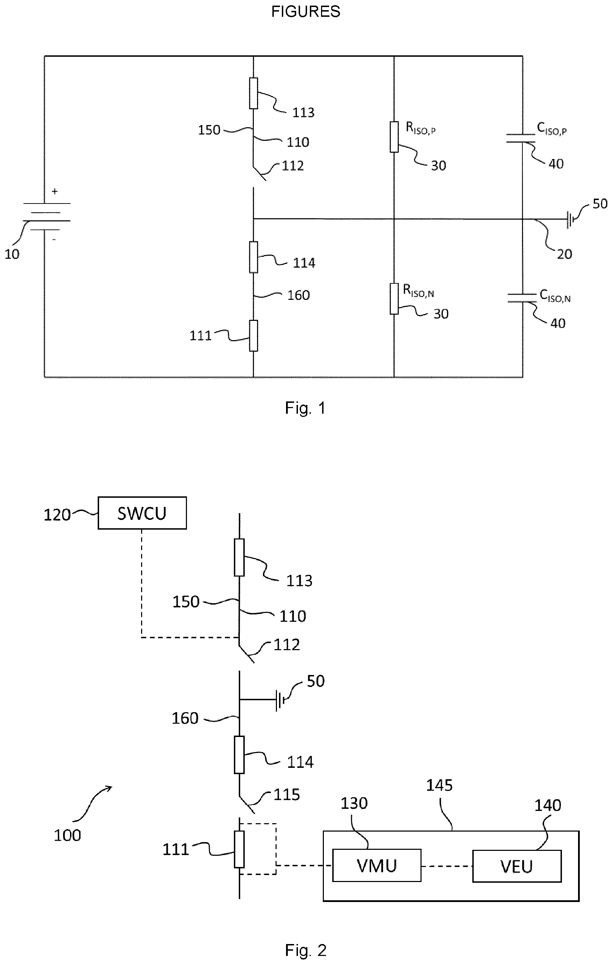

However, in real conditions and as schematically illustrated in figure 1, an electrical separation between the battery 10 and the chassis 50 is also capacitive. Therefore, an electrical connection between the battery 10 and the chassis 50 may also be represented by two capacitors 40, one $C_{ISO,P}$ between the positive terminal (+) of the battery 10 and the chassis 50, and another one $C_{ISO,N}$ between the negative terminal (-) of the battery 10 and the chassis 50. The resistances 30 ($R_{ISO,P}$ and $R_{ISO,N}$) and the capacitors 40 ($C_{ISO,P}$ and $C_{ISO,N}$) are connected in parallel.

In an aspect of the present disclosure, a system 100 for measuring an insulation resistance 30 ($R_{ISO,P}$, $R_{ISO,N}$) between a battery 10 and a chassis 20 of an electrically powered vehicle may be provided. An example of this system is schematically illustrated in figure 2.

The system 100 comprises a voltage divider 110, a switch control unit 120 (SWCU), a voltage measurement unit 130 (VMU) and a voltage extrapolation unit 140 (VEU). The voltage divider 110 includes a first resistor 111 connected in series with a switch 112. The voltage divider 110 is configured to be connected in parallel with the battery 10 and the chassis 50 as e.g. shown in figure 1.

In particular, the voltage divider 110 comprises a first portion 150 and a second portion 160. The first portion 150 is electrically connected to a terminal of the battery 10 and the second portion 160 is electrically connected to the other terminal of the battery 10. In this example, the first portion 150 is connected to the positive (+) terminal of the battery 10 and the second portion 160 is connected to the negative (-) terminal of the battery 10 in figure 1. Independently to which terminal of the battery 10 may be connected to, the first portion 150 includes a switch 112 and the second portion 160 includes a first resistor 111. The second portion is electrically connected 20 to the chassis 50.

Besides electrically connecting the second portion 160 of the voltage divider 110 to the chassis 50, connection 20 electrically also connects the voltage divider 110 and the chassis 50 to the insulation resistance $R_{ISO,P}$ and $R_{ISO,N}$ as well as the capacitors $C_{ISO,P}$ and $C_{ISO,N}$. In addition, when the switch 112 is closed, current may flow between the first 150 and second 160 portions of the voltage divider 110.

Although not illustrated in figure 1, the SWCU 120, VMU 130 and VEU 140 may be connected as shown in the example of figure 2.

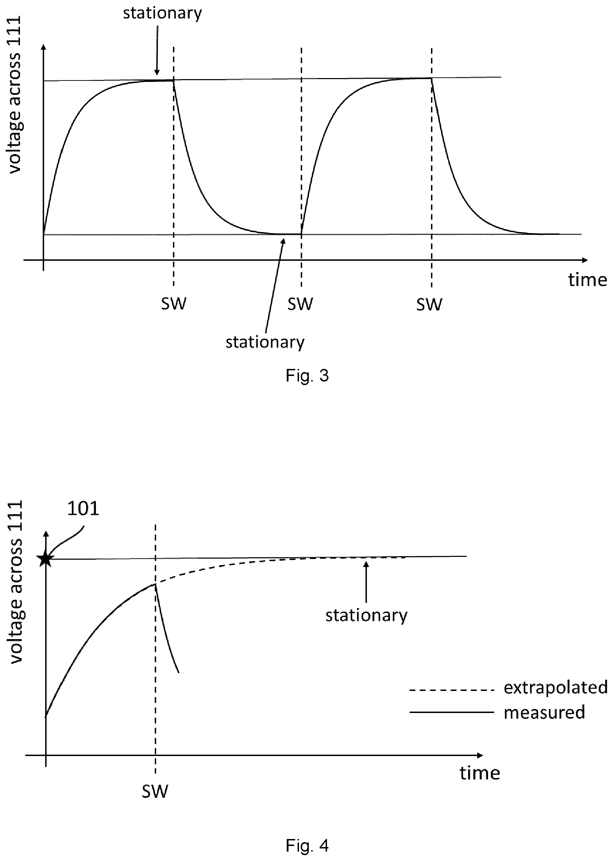

The switch control unit 120 is configured to change a state of the switch 112. The voltage measurement unit 130 is configured to measure the voltage across the first resistor 111. The voltage extrapolation unit 140 is configured to obtain a stationary value 101 (see figure 4) of the voltage at the first resistor 111 by extrapolating two or more voltage values measured by the voltage measurement unit 130. Obtaining may herein be regarded as calculating or estimating or a combination of both.

The voltage measurement unit 130 may measure a plurality of voltages across the first resistor 111 when the switch 112 is in a certain state. A switch may have two states: ON and OFF (or "CLOSED" and "OPEN"). When a switch is in the ON state, the switch is closed and allows current to pass, and when a switch is in the OFF state, the switch is open and does not allow current to pass.

The voltage across the first resistor 111 is not necessarily constant over time, but rather follows an exponential curve, as schematically represented in figures 3 and 4. In particular, when the capacitors 40 are storing energy, i.e. they are charging, the voltage across the first resistor 111 may be low. On the contrary, when the capacitors 40 are discharging, the voltage across the first resistor 112 may increase. Changing the state of the switch 112 (from ON to OFF or from OFF to ON), which has been indicated in figures 3 and 4 with dashed vertical lines labeled as "SW", may thus enable to change from a charge to a discharge process or from a discharge to a charge process of the capacitors 140, and thus change the voltage across the first resistor 111.

Therefore, a plurality of voltage values across the first resistor 111 may be obtained when the switch is in a certain state and another plurality of voltage values across the first resistor 111 may be obtained when the switch is in the other state. These two voltage values may be used to determine the values of the insulation resistance $R_{ISO,P}$ and $R_{ISO,N}$. These voltage values should be stationary values 101 in order to obtain accurate values of $R_{ISO,P}$ and $R_{ISO,N}$. Stationary or "stable" values may be understood as values that no longer evolve over time, but rather that they are stable, as illustrated by horizontal lines in figures 3 and 4. These voltage values may be obtained when a charging or discharging process has finished. I.e., such a discharge or charge process no longer causes variation of the voltage across the first resistor 111 with time.

According to the present disclosure, a plurality of voltage values across the first resistor 111 may be measured by the voltage measurement unit 130 when the switch 112 is in a certain state, i.e. ON or OFF. In some examples, each time the VMU 130 measures a voltage value, it may be transmitted to the voltage extrapolation unit 140. In some other examples, the VMU 130 may also store a set of values before sending them to the VEU 140. In some of these examples, the VMU 130 may measure and store ten voltage values across the first resistor 111 before sending the ten voltage values to the VEU 110. The number of voltage values included in a set of voltage values that the VMU 130 may send to the VEU 140 may be likewise be less or more than ten in other examples.

In case the VMU 130 measures one voltage value and transmits it to the VEU 140 (i.e. no grouping of values is made), the VMU 130 may or may not store such value. If each voltage value is transmitted after a measurement, the transmission may be performed immediately after the measurement. I.e., in this case the VMU 130 does not wait to send the voltage value.

The voltage extrapolation unit 140 may receive the voltage values measured and sent by the voltage measurement unit 130. The solid line in figure 4 represents a plurality of values measured by the VMU 130 and received by the VEU 140 according to an example.

The VEU 140 may use an extrapolation algorithm to determine a first stationary voltage 101 at the first resistor 111. The dashed curve corresponds to an extrapolation curve determined by the VEU 140 based on the measured voltages across the first resistor 111 according to an example. The star 101 illustrates the determined first stationary voltage 101 in this example.

In some examples, the algorithm may use an asymptotic function.

In some examples, the algorithm may use the following equation and work as explained below:

$$V(t) = V_S\left(1 + e^{bt}\right)$$

V(t) represents a voltage across the first resistor 111 at instant t, $V_S$ is the stationary voltage across the first resistor 111 and b is a parameter (constant) related to the resistive and capacitive nature of the circuit.

In some examples, during extrapolation, the parameter b may be varied so as to fit measurements. Extrapolation may be stopped when the parameter b is found which fits sufficiently well with the measurements. The stationary voltage may then be calculated.

A first guess of the parameter b may be provided. Such a first guess might be based e.g. on values determined in previous occasions. This value and a plurality of voltage measurements (solid curve in figure 4) across the first resistor 111 may be introduced in the above equation (written in vector form) in order to get a first estimation of $V_S$. If in a subsequent iteration, the same $V_S$ value is found, it may be concluded that the parameter b was determined correctly. If however, subsequent determinations of Vs differ more than a threshold value from each other, then the parameter b may be adapted.

In other words, the $V_S$ value is used to calculate the function V(t) according to the above equation (dashed curve in figure 4) and compared to the measured V(t) values, to see if the assumed value for "b" is correct.

If the difference between these curves is less than a predetermined threshold, the calculated voltage curve (solid line in figure 4) and the measured data (dashed line in figure 4) are deemed to be close enough and the value $V_S$ 101 is deemed to have been found.

If the difference is more than the predetermined threshold, another approximation of the parameter b may be calculated. This new value of b may be then used to calculate or estimate $V_S$ in a subsequent iteration. This process may be repeated until the calculated curve of the voltages across the first resistor 111 is deemed to be close enough to the measured voltages. When this happens, a stationary value $V_S$ 111 is deemed to have been found.

In some of these examples, a Newton-Raphson method may be used during the extrapolation. In particular, this method may be used to find a better approximation of the parameter b mentioned above.

This extrapolated voltage value 101 may correspond to a voltage that the VMU 130 may measure later in the stationary state (i.e. when stationary voltage may be measured) if the measurement process was not interrupted, i.e. once a charging or discharging process has ended and the voltage across the first resistor 111 no longer varies due to such a process.

However, due to the extrapolation process, it is not necessary to wait until the voltage value stabilizes to know what the stationary value 101 may be, but a first stationary voltage 101 may be determined in advance by the VEU 140 from the values it received from the VMU 130 (black curve in figure 4).

The voltage extrapolation unit 140 may interrupt, i.e. end, the extrapolation process and send a signal to the switch control unit 120 indicating the SWCU 120 to change the state of the switch 112.

In some examples, the VEU 140 may interrupt the extrapolation process after a certain period of time has elapsed. In some other examples, the VEU 140 may interrupt the extrapolation after having determined a stationary voltage value 101 across the first resistor 111 which is deemed sufficiently precise. For example, if a difference between a stationary voltage determined in a current step and in the previous step is less than a predetermined threshold, the extrapolated stationary voltage value in the current step may be deemed precise enough and the extrapolation process may be stopped.

As illustrated by a dashed vertical line in figure 4, once the switch control unit 120 has received the indication from the voltage extrapolation unit 140, the SWCU 120 may change the state of the switch 112.

As the state of the switch 112 may have changed well before the arrival to the stationary state due to the use of an extrapolation process to anticipate a stationary voltage 101 across the first resistor 111, time may have been saved in the subsequent calculation of the insulation resistance 30.

Due to the change of the state of the switch 112, the voltage across the first resistor 111 has also changed and a second plurality of voltage values across the first resistor 111 may be measured by the voltage measurement unit 130 and a second stationary voltage at the first resistor 111 may be extrapolated by the VEU 140. Again, the extrapolation process may enable the reduction of the time necessary to arrive to a stationary value 101 of the voltage across the first resistor 111.

Two values of the stationary voltage across may be sufficient to calculate the insulation resistance $R_{ISO,P}$ and $R_{ISO,N}$. This may be explained further below.

The voltage measurement unit 130, the voltage extrapolation unit 140 and the switch control unit 120 may each comprise a memory including instructions and a processor configured to execute the instructions stored in the memory. For example, the VMU 130 may include instructions for measuring the voltage across the first resistor 111 at a certain frequency, the VEU 140 may include instructions for performing an extrapolation method and interrupting it when a condition is met, and the SWCU 120 may include instructions for changing the state of the switch 112 upon receiving signaling from the VEU 140.

The VMU 130 may comprise measurement elements configured to measure a voltage across the first resistor 111. In an example, the VMU 130 may include a voltmeter to this end.

In some examples, as illustrated in figure 2, the VMU 130 and the VEU 140 may be part of an estimation unit 145. The VMU 130 and the VEU 140 may communicate through wires or wirelessly. Likewise, the VEU 140 and the SWCU 120 may communicate through wires or wirelessly. In some of these examples, the estimation unit 145 may be a single unit, i.e. the estimation unit (including VMU and VEU) may be integrated in a single chip or may be included in a chip.

In some examples, the voltage divider 110 may further comprise a second 113 and third 114 resistors connected in series with the first resistor 111 and the switch 112, the third resistor 114 being placed between the first 111 and second 113 resistors.

In particular, the first portion 150 of the voltage divider 110 may further comprise a second resistor 113 and the second portion 160 of the voltage divider may further comprise a third resistor 114. The electrical connection 20 between the voltage divider 110 and the chassis 50 may be provided between the switch 112 and the third resistor 114.

In some examples, the resistance of the second 113 and third 114 resistors may be higher than the resistance of the first resistor 111. In some examples, the resistance of the second 113 and third 114 resistors may be similar or substantially equal.

Having the second 113 and third 114 resistors may enable a decrease in the current circulating in the voltage divider 110, in particular when the resistance of the second 113 and third 114 resistors have values of resistance larger than the first 111 resistor. Safety may be increased by the presence of the second 113 and third 114 resistors.

In some examples, the resistance of the second 113 and third 114 resistors may be between 100 and 400 times larger than the resistance of the first resistor 111. In an example, the first resistor 111 may have a resistance of 1600 ohms and the second 113 and third 114 resistors may have a resistance of 550000 ohms.

In some examples, the resistance values of the first 111 resistor may be adjusted, e.g. optimized, such that voltages between 0 and 5 volts, and more in particular between 1.5 and 3.5 volts, may be measured by the voltage measurement unit 130.

In some examples, the switch 112 may be connected between the second 113 and third 114 resistors, as shown in figures 1 and 2. An electrical connection 20 between the switch 112 and the third resistor 114 and the chassis 50 may be provided as illustrated in figure 1. For example, a wire connecting the switch 112 and the third resistor 114 may be put in electrical connection 20 with the chassis 50.

As schematically illustrated in figures 1 and 2, the chassis 50 may be regarded as including a connection to the ground. a connection to the ground may be provided between the switch 112 and the third resistor 114. Accordingly, when the voltage divider 110 is connected in parallel with the battery 10 and the chassis 50, current may always flow through the first resistor 111 no matter the state of the switch 112 (ON or OFF).

In some examples, the voltage divider 110 may further comprise an additional switch 115 between the first 111 and the third 114 resistors. The additional switch 115 is not configured to be used with relation to the extrapolation procedure and the insulation resistance 300 determination. The additional switch 115 may be used merely to ensure that an insulation exists between each terminal of the battery 10 and the chassis 50 once the voltage divider 110 is connected to it.

In another aspect of the invention, a method 200 for measuring an insulation resistance 300 $R_{ISO,P}$, $R_{ISO,N}$ between a battery 10 and a chassis 50 of an electrically powered vehicle is provided. The method 200 is performed by the system for measuring an insulation resistance 100 referred to with respect to figures 1 and 2. Thus, the system 100, in particular the voltage divider 110, is connected in parallel with the battery 10 and the chassis 50 . In some examples, the first portion 150 of the voltage divider 110 may be connected to the positive terminal (+) of the battery 10 and the second portion 160 of the voltage divider 110 may be connected to the negative (-) terminal of the battery 10, as illustrated in figure 1. The extrapolation concepts described with regard to figure 4 also apply to this method.

The method comprises, at block 210, starting the battery 10. Therefore, the vehicle may be powered and current may flow through the electrical circuit formed by the battery 10, the chassis 50 and the voltage divider 110.

The switch 112 is either open (OFF) or closed (ON). In some examples the switch 112 may be open, and in some other examples the switch 112 may be closed.

The method further comprises, at block 220, measuring a first plurality of voltages across the first resistor 111 by the voltage measurement unit 130.

The voltage values may be measured at a certain frequency. In some examples, the first plurality of voltages across the first resistor 111 may be measured at a frequency between 20 and 500 Hz, for instance at about 100 Hz.

In other words, in some examples, a time between two consecutive measurements of a voltage value across the first resistor 111 may be between 2 and 50 milliseconds. In an example, a voltage value across the first resistor 111 may be measured each 10 milliseconds.

In some examples, the frequency of measurements or time between consecutive measurements of a voltage value across the first resistor 111 may vary. For example, the frequency of measurement (and possibly the corresponding calculation) may be higher when the extrapolation is closer to being stopped, than the frequency of the "first" measurements, at the beginning of extrapolation.

In some examples, the voltage measurement unit 130 may send each measured voltage value to the voltage extrapolation unit 140 immediately after the measurement. In some other examples, the VMU 130 may store a set of voltage measurements before sending them to the VEU 140. In an example, the VMU 130 may send sets of ten voltage values measured across the first resistor 111 after the tenth voltage value has been acquired.

In some examples the first plurality of voltages across the first resistor 111 measured by the VMU 130 may include between 30 and 300 measurements, more in particular between 50 and 100 measurements, and even more in particular between 60 and 80 measurements.

The method further comprises, at block 230, by the voltage extrapolation unit 140, determining a first stationary voltage 101 across the first resistor 111 based on an extrapolation of the first plurality of voltages and interrupting the extrapolation.

The VEU 140 may use any suitable extrapolation method. In some examples, a Newton-Raphson method may be used during the extrapolation.

In some examples, the determination may be performed before the interruption of the extrapolation. That is to say, the VEU 140 may determine a stationary voltage, and since a stationary voltage has been determined, the extrapolation is stopped.

In some of these examples, a stationary voltage 101 may be deemed found after a condition is met. In an example, a stationary voltage may be deemed found by the VEU 140 when a difference between an extrapolated voltage value in a current iteration of the extrapolation and an extrapolated voltage value in the previous iteration of the extrapolation is below a predetermined threshold.

In some examples, the determination may be performed after the interruption of the extrapolation. In some of these examples, the VEU 140 may interrupt the extrapolation after a certain period of time, e.g. a predetermined period of time, has elapsed. The VEU 140 may select the latest estimated stationary voltage value as the first stationary voltage in some examples.

Determining first and interrupting after the determination may enhance the flexibility of the method, as the time and voltage measurements required for determining a first stationary voltage may vary depending e.g. on which electrical vehicle the system 100 may be mounted to.

In some examples, measuring the first plurality of voltage values (block 220) and determining a first stationary voltage and interrupting the extrapolation (block 230) may be performed in less than 1 second, optionally between 0.6 and 0.8 seconds.

The method further comprises, at block 240, changing a state of the switch 120 by the switch control unit 120.

Once the VEU 140 has determined a first stationary voltage 101 across the first resistor 111, the VEU 140 may send to the SWCU 120 an instruction to change the state of the switch 112 after the determination of a first stationary voltage at the first resistor 111 and interruption of the extrapolation.

The SWCU 120 may receive the instruction of the VEU 140 and thus change the state of the switch 112. In some examples the switch may be closed if it was open during steps 220 and 230, and *vice versa* in some other examples.

In accordance herewith, once the extrapolation is stopped, e.g. after a stationary voltage value has been determined, the state of the switch 112 will change. If the state of the switch 112 changes from OFF to ON, current may flow between the first 150 and second 160 portions of the voltage divider 110.

The method further comprises, at block 250, measuring a second plurality of voltages across the first resistor 111 by the voltage measurement unit 130.

The particularities commented above with respect to the measurement of the first plurality of voltages across the first resistor 111 may apply to the measurement of the second plurality of voltages.

In some examples, a frequency of measurements (and possibly corresponding calculations) may vary during the first plurality of measurements (at block 220). For example, the frequency of measurement (and possibly the corresponding calculation) may be higher when the extrapolation is closer to being stopped, than the frequency of the "first" measurements, at the beginning of extrapolation.

In some examples, the voltage measurement unit 130 may send each measured voltage value to the voltage extrapolation unit 140 immediately after the measurement.

In some examples the first plurality of voltages across the first resistor 111 measured by the VMU 130 may include between 30 and 300 measurements, more in particular between 50 and 100 measurements, and even more in particular between 60 and 80 measurements.

The method may further comprise, at block 260, determining a second stationary voltage across the first resistor 111 based on an extrapolation by the voltage extrapolation unit 140, of the second plurality of voltages and interrupting the extrapolation.

The particularities commented above with respect to the steps 230 may apply to the step 260 as well. The VEU 140 may use any suitable extrapolation method. In some examples, a Newton-Raphson method may be used during the extrapolation. In some examples, the determination of the second stationary voltage may be performed before the interruption of the extrapolation. In some examples, measuring the second plurality of voltage values (block 250) and determining a second stationary voltage and interrupting the extrapolation (block 260) may be performed in less than 1 second, optionally between 0.6 and 0.8 seconds.

The method may further comprise, at block 270, calculating the insulation resistance 300 $R_{ISO,P}$ and $R_{ISO,N}$ using the determined first and second stationary voltages across the first resistor.

In some examples, the voltage extrapolation unit 140 may perform this calculation. In some other examples, the estimation unit 145 may perform this calculation. For example, the estimation unit 145 may include a memory with instructions for calculating the insulation resistance 300 and a processor able to perform the calculation according to the stored instructions. Still in some other examples, another unit included in the system 100 may perform this task.

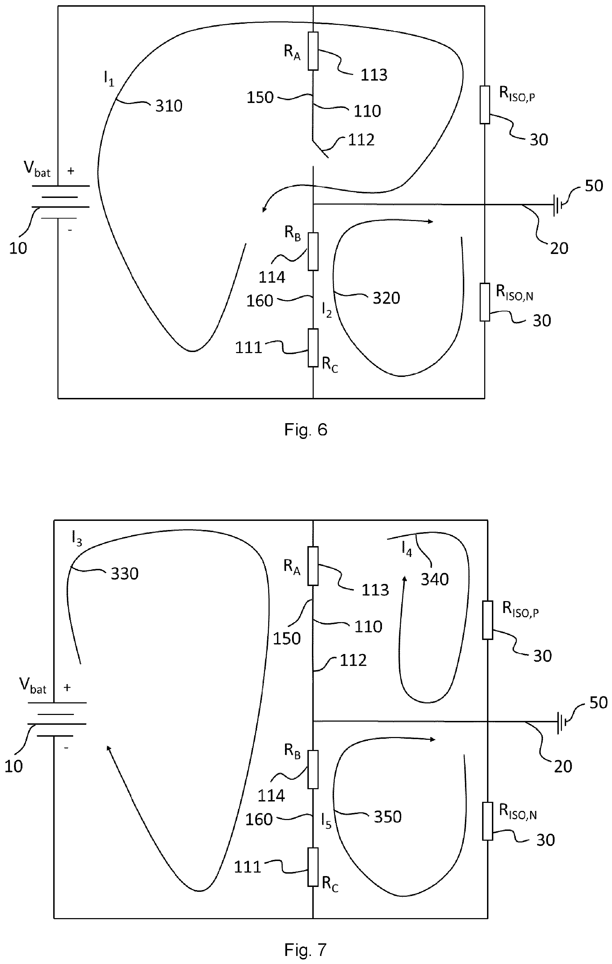

In some examples, calculating the insulation resistance 300 may comprise solving an equation system based on Kirchhoff's laws. Kirchhoff's laws are well known to the skilled person. The equations may be formulated according the electrical circuits that may be formed when the switch is in one state and when the switch is in the other state. As the first and second determined voltages across the first resistor 111 are values relating to the stationary state, the electrical circuit illustrated in figure 1 may be represented without capacitors 40, e.g. as represented in figures 6 and 7.

In some of these examples, mesh analysis, also known as mesh current method, may be used to write a system of five equations. Figures 6 and 7 illustrate an application of mesh analysis according to an example.

In figure 6 the switch 112 is open, e.g. during the determination of the first stationary voltage across the first resistor 111, and according to the mesh current method, currents $I_1$ 310 and $I_2$ 320 may be represented as shown in this figure.

In view of figure 6, two equations with four unknowns, namely currents $I_1$ 310 and $I_1$ 320 as well as the insulation resistance $R_{ISO,P}$ and $R_{ISO,N}$, may be determined for the situation in which the switch is open. These two equations may look as follows:

$$V_{bat} - I_1(R_{ISO.P} + R_B + R_C) + I_2(R_B + R_C) = 0$$

$$-I_2(R_{ISO,N} + R_B + R_C) + I_1(R_B + R_C) = 0$$

Similarly, in figure 7 the switch 112 is closed, e.g. during the determination of the second stationary voltage across the first resistor 111, and according to the mesh current method, currents $I_3$ 330, $I_4$ 340 and $I_5$ 350 may be represented as shown in this figure.

In view of figure 7, three equations with four unknowns (currents $I_3$ 330, $I_4$ 340 and $I_5$ 350, as well as the insulation resistance $R_{ISO,P}$ and $R_{ISO,N}$), may be written. These three equations may look as follows:

$$V_{bat} - I_3(R_A + R_B + R_C) + I_4 R_A + I_5(R_B + R_C) = 0$$

$$-I_4(R_{ISO,P} + R_A) + I_3 R_A = 0$$

$$-I_5(R_{ISO,N} + R_B + R_C) + I_3(R_B + R_C) = 0$$

By knowing the determined first and second stationary voltages across the first resistor 111, these values may be introduced in the abovementioned equations, thereby obtaining a system of five equations with 5 unknowns (currents $I_1$ 310, $I_3$ 330 and $I_4$ 340 and the insulation resistance $R_{ISO,P}$ and $R_{ISO,N}$).

Accordingly, by solving such equation system, the insulation resistance 300 $R_{ISO,P}$ and $R_{ISO,N}$ may be calculated at block 270 according to an example.

In some examples a value for the insulation resistance $R_{ISO,P}$ and $R_{ISO,N}$ may be calculated in less than 2 seconds, optionally in less than 1.5 seconds, after the start of the method.

In some examples, the method further comprises starting the vehicle if the calculated insulation resistance is above a predetermined threshold.

In some examples, if a calculated insulation resistance value is below a predetermined threshold, the vehicle may not be started. In some of these examples, a signal indicating such an event may be emitted. For instance, an acoustic signal may be emitted, or an alarm may appear on a vehicle display. In some examples, the system or device for measuring an insulation resistance may be configured to intervene directly on the battery system.

In some examples, more than two pluralities of voltage across the first resistor 111 may be measured by the voltage measurement unit 130. Thus, in some examples, the voltage extrapolation unit 140 may determine more than two stationary voltage values across the first resistor 111, i.e. it may perform more than two extrapolations. In some of these examples, the stationary voltages for each state of the switch 112 may be selected among the available values for the calculation of the insulation resistance 30. In some other examples, the stationary voltages for each state of the switch 112 may be averaged (one averaging operation per switch state) for the calculation of the insulation resistance 30.

Although only a number of examples have been disclosed herein, other alternatives, modifications, uses and/or equivalents thereof are possible. Furthermore, all possible combinations of the described examples are also covered. Thus, the scope of the present disclosure should not be limited by particular examples, but should be determined only by a fair reading of the claims that follow.

**Claims**

1. A method (200) for measuring an insulation resistance (30) between a battery (10) and a chassis (50) of an electrically powered vehicle, wherein

   one terminal of the battery (10) is electrically connected to a first portion (150) of a voltage divider (110) comprising a switch (112), and wherein
   another terminal of the battery (10) is electrically connected to a second portion (160) of the voltage divider (110) comprising a first resistor (111), wherein
   when the switch (112) is in a closed state a flow of current is allowed between the first portion (150) and the second portion (160) of the voltage divider (110), the method (200) comprising:

   starting the battery;
   measuring (220) by a voltage measurement unit (130) a first plurality of voltages across the first resistor (111) of the voltage divider (110);
   determining (230) a first stationary voltage across the first resistor (111) based on an extrapolation of the first plurality of voltages by a voltage extrapolation unit (140), and interrupting the extrapolation;
   changing (240) a state of the switch (112) by a switch control unit (120);
   after changing (240) the state of the switch (112), measuring (250) a second plurality of voltages across the first resistor (111) by the voltage measurement unit (130);
   determining (260) a second stationary voltage across the first resistor (111) based on an extrapolation of the second plurality of voltages by the voltage extrapolation unit (140), and interrupting the extrapolation; and
   calculating (270) the insulation resistance (30) using the determined first and second stationary voltages across the first resistor (111).

2. The method of claim 1, wherein measuring (220, 250) a plurality of voltage values and determining (230, 260) a corresponding stationary voltage and interrupting the extrapolation are performed in less than 1 second, optionally between 0.6 and 0.8 seconds.

3. The method of claim 1 or 2, wherein a Newton-Raphson method is used during an extrapolation.

4. The method of any of claims 1 - 3, wherein the voltage measurement unit (130) sends each measured voltage value to the voltage extrapolation unit (140) immediately after the measurement.

5. The method of any of claims 1 - 4, wherein the determination (230, 260) of a stationary voltage is performed before the interruption of the extrapolation.

6. The method of any of claims 1 - 5, further comprising sending, by the voltage extrapolation unit (140) to the switch control unit (120), an instruction to change the state of the switch (112) after the determination (230, 260) of a stationary voltage at the first resistor (111) and interruption of the extrapolation.

7. The method of any of claims 1 - 6, wherein calculating (270) the insulation resistance (30) comprises solving an equation system based on Kirchhoff's laws.

8. The method of any of claims 1 - 7, further comprising starting the vehicle if the calculated insulation resistance (30) is above a predetermined threshold.

9. A system (100) for measuring an insulation resistance between a battery (10) comprising two terminals and a chassis (50) of an electrically powered vehicle, the system (100) comprising:

   a voltage divider (110) comprising:

   a first portion (150) configured to be connected to a terminal of the battery (10), the first portion (150) including a switch (112), and
   a second portion (160) configured to be connected to the other terminal of the battery (10), the second portion (160) including a first resistor (111);

   a switch control unit (120) configured to change a state of the switch (112) such that when the switch (112) is closed, current flows between the first (150) and second (160) portions of the voltage divider (110);
   a voltage measurement unit (130) configured to measure the voltage across the first resistor (111); and
   a voltage extrapolation unit (140) configured to obtain a stationary value of the voltage at the first resistor (111) by extrapolating two or more voltage values measured by the voltage measurement unit (130).

10. The system of claim 9, wherein the first portion (150) of the voltage divider (110) further comprises a second resistor (113) connected in series with the switch (112) and the second portion (160) of the voltage divider (110) further comprises a third resistor (114) connected in series with the first resistor (111), the third resistor (114) being placed between the second (113) and first (111) resistors.

11. The system of claim 10, wherein the switch (112) is connected between the second (113) and third (114) resistors.

12. The system of claims 10 or 11, wherein a connection (20) to the ground is provided between the switch (112) and the first resistor (111).

13. The system of any of claims 10 to 12, wherein the resistance of the second (113) and third (114) resistors is larger than the resistance of the first resistor (111).

14. The system of any of claims 10 to 13, further comprising an additional switch (115) between the first (111) and third (114) resistors.


**Patentansprüche**

1. Verfahren (200) zum Messen eines Isolationswiderstands (30) zwischen einer Batterie (10) und einem Chassis (50) eines elektrisch angetriebenen Fahrzeugs, wobei

   ein Pol der Batterie (10) elektrisch mit einem ersten Abschnitt (150) eines Spannungsteilers (110) verbunden ist, der einen Schalter (112) umfasst, und wobei
   ein anderer Pol der Batterie (10) elektrisch mit einem zweiten Abschnitt (160) des Spannungsteilers (110) verbunden ist, der einen ersten Widerstand (111) umfasst, wobei
   wenn sich der Schalter (112) in einem geschlossenen Zustand befindet, ein Stromfluss zwischen dem ersten Abschnitt (150) und dem zweiten Abschnitt (160) des Spannungsteilers (110) zugelassen wird, wobei das Verfahren (200) umfasst:

   Starten der Batterie;
   Messen (220) einer ersten Vielzahl von Spannungen über dem ersten Widerstand (111) des Spannungsteilers (110) durch eine Spannungsmesseinheit (130);
   Bestimmen (230) einer ersten stationären Spannung über dem ersten Widerstand (111) basierend auf einer Extrapolation der ersten Vielzahl von Spannungen durch eine Spannungsextrapolationseinheit (140), und Unterbrechen der Extrapolation;

Ändern (240) eines Zustands des Schalters (112) durch eine Schaltersteuereinheit (120);

nach dem Ändern (240) des Zustands des Schalters (112), Messen (250) einer zweiten Vielzahl von Spannungen über dem ersten Widerstand (111) durch die Spannungsmesseinheit (130);

Bestimmen (260) einer zweiten stationären Spannung über dem ersten Widerstand (111) basierend auf einer Extrapolation der zweiten Vielzahl von Spannungen durch die Spannungsextrapolationseinheit (140) und Unterbrechen der Extrapolation; und

Berechnen (270) des Isolationswiderstandes (30) unter Verwendung der ermittelten ersten und zweiten stationären Spannungen über dem ersten Widerstand (111).

2. Verfahren nach Anspruch 1, bei dem das Messen (220, 250) einer Vielzahl von Spannungswerten und das Bestimmen (230, 260) einer entsprechenden stationären Spannung und das Unterbrechen der Extrapolation in weniger als einer Sekunde, optional zwischen 0,6 und 0,8 Sekunden, durchgeführt werden.

3. Verfahren nach Anspruch 1 oder 2, wobei während einer Extrapolation ein Newton-Raphson-Verfahren verwendet wird.

4. Verfahren nach einem der Ansprüche 1 bis 3, wobei die Spannungsmesseinheit (130) jeden gemessenen Spannungswert unmittelbar nach der Messung an die Spannungsextrapolationseinheit (140) sendet.

5. Verfahren nach einem der Ansprüche 1 bis 4, wobei die Bestimmung (230, 260) einer stationären Spannung vor der Unterbrechung der Extrapolation durchgeführt wird.

6. Verfahren nach einem der Ansprüche 1 bis 5, das ferner umfasst, dass die Spannungsextrapolationseinheit (140) nach der Bestimmung (230, 260) einer stationären Spannung am ersten Widerstand (111) und der Unterbrechung der Extrapolation einen Befehl zum Ändern des Zustands des Schalters (112) an die Schaltersteuereinheit (120) sendet.

7. Verfahren nach einem der Ansprüche 1 bis 6, wobei die Berechnung (270) des Isolationswiderstands (30) das Lösen eines Gleichungssystems auf der Grundlage der Kirchhoffschen Gesetze umfasst.

8. Verfahren nach einem der Ansprüche 1 bis 7, das ferner das Anlassen des Fahrzeugs umfasst, wenn der berechnete Isolationswiderstand (30) über einem vorgegebenen Schwellenwert liegt.

9. Ein System (100) zum Messen eines Isolationswiderstandes zwischen einer Batterie (10) mit zwei Anschlüssen und einem Chassis (50) eines elektrisch angetriebenen Fahrzeugs, wobei das System (100) umfasst:

einen Spannungsteiler (110), der Folgendes umfasst:

einen ersten Abschnitt (150), der so konfiguriert ist, dass er mit einem Anschluss der Batterie (10) verbunden werden kann, wobei der erste Abschnitt (150) einen Schalter (112) enthält, und

einen zweiten Abschnitt (160), der so konfiguriert ist, dass er mit dem anderen Anschluss der Batterie (10) verbunden wird, wobei der zweite Abschnitt (160) einen ersten Widerstand (111) enthält;

eine Schaltersteuereinheit (120), die so konfiguriert ist, dass sie einen Zustand des Schalters (112) so ändert, dass, wenn der Schalter (112) geschlossen ist, Strom zwischen dem ersten (150) und dem zweiten (160) Abschnitt des Spannungsteilers (110) fließt;

eine Spannungsmesseinheit (130), die so konfiguriert ist, dass sie die Spannung an dem ersten Widerstand (111) misst; und

eine Spannungsextrapolationseinheit (140), die so konfiguriert ist, dass sie einen stationären Wert der Spannung am ersten Widerstand (111) durch Extrapolation von zwei oder mehr von der Spannungsmesseinheit (130) gemessenen Spannungswerten erhält.

10. System nach Anspruch 9, wobei der erste Teil (150) des Spannungsteilers (110) ferner einen zweiten Widerstand (113) umfasst, der in Reihe mit dem Schalter (112) geschaltet ist, und der zweite Teil (160) des Spannungsteilers (110) ferner einen dritten Widerstand (114) umfasst, der in Reihe mit dem ersten Widerstand (111) geschaltet ist, wobei der dritte Widerstand (114) zwischen dem zweiten (113) und dem ersten (111) Widerstand angeordnet ist.

11. System nach Anspruch 10, wobei der Schalter (112) zwischen dem zweiten (113) und dem dritten (114) Widerstand angeschlossen ist.

**12.** System nach Anspruch 10 oder 11, wobei eine Verbindung (20) zur Masse zwischen dem Schalter (112) und dem ersten Widerstand (111) vorgesehen ist.

**13.** System nach einem der Ansprüche 10 bis 12, wobei der Widerstand des zweiten (113) und dritten (114) Widerstands größer ist als der Widerstand des ersten Widerstands (111).

**14.** System nach einem der Ansprüche 10 bis 13, das außerdem einen zusätzlichen Schalter (115) zwischen dem ersten (111) und dem dritten (114) Widerstand umfasst.


**Revendications**

**1.** Procédé (200) de mesure d'une résistance d'isolement (30) entre une batterie (10) et un châssis (50) d'un véhicule à propulsion électrique, dans lequel

une borne de la batterie (10) est connectée électriquement à une première partie (150) d'un diviseur de tension (110) comprenant un commutateur (112), et dans lequel
une autre borne de la batterie (10) est connectée électriquement à une deuxième partie (160) du diviseur de tension (110) comprenant une première résistance (111), dans laquelle
lorsque l'commutateur (112) est fermé, un flux de courant est autorisé entre la première partie (150) et la seconde partie (160) du diviseur de tension (110), le procédé (200) comprenant
le démarrage de la batterie ;
mesurer (220) par une unité de mesure de la tension (130) d'une première série de tensions aux bornes de la première résistance (111) du diviseur de tension (110) ;
détermination (230) d'une première tension stationnaire aux bornes de la première résistance (111) sur la base d'une extrapolation de la première pluralité de tensions par une unité d'extrapolation de tension (140), et interruption de l'extrapolation ;
changer (240) l'état de l'commutateur (112) par une unité de commande d'commutateur (120) ;
après avoir modifié (240) l'état de l'commutateur (112), mesurer (250) une deuxième série de tensions aux bornes de la première résistance (111) par l'unité de mesure de tension (130) ;
déterminer (260) une deuxième tension stationnaire aux bornes de la première résistance (111) sur la base d'une extrapolation de la deuxième pluralité de tensions par l'unité d'extrapolation de tension (140), et interrompre l'extrapolation ; et
calculer (270) la résistance d'isolement (30) à l'aide des première et deuxième tensions stationnaires déterminées aux bornes de la première résistance (111).

**2.** Procédé de la revendication 1, dans laquelle la mesure (220, 250) d'une pluralité de valeurs de tension et la détermination (230, 260) d'une tension stationnaire correspondante et l'interruption de l'extrapolation sont effectuées en moins d'une seconde, éventuellement entre 0,6 et 0,8 seconde.

**3.** Procédé de la revendication 1 ou 2, dans laquelle une méthode de Newton-Raphson est utilisée lors d'une extrapolation.

**4.** Procédé de l'une des revendications 1 à 3, dans laquelle l'unité de mesure de la tension (130) envoie chaque valeur de tension mesurée à l'unité d'extrapolation de la tension (140) immédiatement après la mesure.

**5.** Procédé de l'une des revendications 1 à 4, dans laquelle la détermination (230, 260) d'une tension stationnaire est effectuée avant l'interruption de l'extrapolation.

**6.** Procédé de l'une des revendications 1 à 5, comprenant en outre l'envoi, par l'unité d'extrapolation de la tension (140) à l'unité de commande du commutateur (120), d'une instruction pour changer l'état du commutateur (112) après la détermination (230, 260) d'une tension stationnaire au niveau de la première résistance (111) et l'interruption de l'extrapolation.

**7.** Procédé de l'une des revendications 1 à 6, dans laquelle le calcul (270) de la résistance d'isolement (30) comprend la résolution d'un système d'équations basé sur les lois de Kirchhoff.

**8.** Procédé de l'une des revendications 1 à 7, comprenant en outre le démarrage du véhicule si la résistance d'isolation calculée (30) est supérieure à un seuil prédéterminé.

**9.** Système (100) pour mesurer une résistance d'isolement entre une batterie (10) comprenant deux bornes et un châssis (50) d'un véhicule à propulsion électrique, le système (100) comprenant :

un diviseur de tension (110) comprenant :

une première partie (150) configurée pour être connectée à une borne de la batterie (10), la première partie (150) comprenant un commutateur (112), et
une deuxième partie (160) configurée pour être connectée à l'autre borne de la batterie (10), la deuxième partie (160) comprenant une première résistance (111) ;

une unité de commande de commutateur (120) configurée pour changer l'état du commutateur (112) de sorte que lorsque le commutateur (112) est fermé, le courant circule entre la première (150) et la deuxième (160) parties du diviseur de tension (110) ;
une unité de mesure de la tension (130) configurée pour mesurer la tension aux bornes de la première résistance (111) ; et
une unité d'extrapolation de la tension (140) configurée pour obtenir une valeur stationnaire de la tension au niveau de la première résistance (111) en extrapolant deux valeurs de tension ou plus mesurées par l'unité de mesure de la tension (130).

**10.** Système de la revendication 9, dans lequel la première partie (150) du diviseur de tension (110) comprend en outre une deuxième résistance (113) connectée en série avec le commutateur (112) et la deuxième partie (160) du diviseur de tension (110) comprend en outre une troisième résistance (114) connectée en série avec la première résistance (111), la troisième résistance (114) étant placée entre la deuxième (113) et la première (111) résistances.

**11.** Système de la revendication 10, dans lequel le commutateur (112) est connecté entre les deuxième (113) et troisième (114) résistances.

**12.** Système des revendications 10 ou 11, dans lequel une connexion (20) à la terre est prévue entre le commutateur (112) et la première résistance (111).

**13.** Système de l'une des revendications 10 à 12, dans lequel la résistance des deuxième (113) et troisième (114) résistances est plus grande que la résistance de la première résistance (111).

**14.** Système de l'une des revendications 10 à 13, comprenant en outre un commutateur supplémentaire (115) entre la première (111) et la troisième (114) résistances.

FIGURES

Fig. 1

Fig. 2

Fig. 3

Fig. 4

EP 4 019 990 B1

200

Starting the battery — 210

Measuring a first plurality of voltages — 220

Determining a first stationary voltage and interrupting the extrapolation — 230

Changing a state of the switch — 240

Measuring a second plurality of voltages — 250

Determining a second stationary voltage and interrupting the extrapolation — 260

Calculating the insulation resistance — 270

Fig. 5

16

Fig. 6

Fig. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20170016951 A1